# EUROPEAN PATENT APPLICATION

(11) **EP 4 571 841 A1**
(43) Date of publication of application: **18.06.2025**
(21) Application number: 23216321.2
(22) Date of filing: 13.12.2023
(51) Int. Cl.: H01L 29/10, H01L 29/20, H01L 29/78, H01L 29/36, H01L 21/336

(54) **III-NITRIDE FIELD EFFECT TRANSISTOR**

(71) Applicant: Imec VZW, 3001 Leuven (BE)
(72) Inventor: BAKEROOT, Benoit, 9000 Gent (BE)
(74) Representative: Winger

(57) **Abstract**

A field effect transistor (1) comprising:
a III-nitride semiconductor stack comprising a III-nitride semiconductor material, the III-nitride semiconductor stack comprising: a drain layer (21), a drift layer (22), a body layer (23, 24), and a source layer (25),
an n-doped region (3), formed of the III-nitride semiconductor material, extending from the drift layer into a first part of the body layer, wherein a height in the stack of a top surface of the n-doped region is located below a height in the stack of a top of the body layer, and
a trench (5, 6) extending from a top surface of the III-nitride semiconductor stack, through the source layer, and only an upper part of the body layer, wherein said upper part is adjacent to the first part,
a gate dielectric (5) covering surfaces of the trench,
a gate electrode (6) over the gate dielectric, wherein a first region of a bottom surface of the gate dielectric is in physical contact with the top surface of the n-doped region (3).

## Description

### Technical field of the invention

The present invention relates to the field of III-nitride semiconductor field effect transistors; in particular, the present invention relates to vertical or semi-vertical field effect transistors.

### Background of the invention

The field of semiconductor devices, particularly those designed for high-voltage applications, has seen significant advancements over the years. These devices are critical components in a variety of applications, including power electronics, electric vehicles, and renewable energy systems. Among the materials used for such devices, III-nitride semiconductor materials, in particular gallium nitride (GaN), have emerged as a promising candidate due to its good properties such as high electron mobility, wide bandgap, and high breakdown voltage.

In the realm of high-voltage semiconductor devices, a particular class of devices known as vertical field-effect transistors (FETs) has gained attention. These devices are designed to handle very high OFF-state voltages, which are blocked by an epitaxially grown horizontal pn junction, typically the p-body to n-drift junction. The n-drift layer, being lowly doped, is responsible for sustaining most of the voltage in the OFF-state.

However, a significant challenge arises in the design of vertical GaN devices, particularly concerning the high electric fields that occur at the gate trench corners. In a conventional vertical GaN device design, the gate trench penetrates into the n-drift layer, leading to a situation where the gate oxide at the bottom of the trench experiences a high voltage difference in the OFF-state. This difference is between the gate metal, which is at zero voltage in the OFF-state, and the n-drift layer connected to the drain electrode at high voltage. Such conditions can lead to premature device failure due to gate oxide breakdown or other forms of electrical stress at the gate trench corners.

The industry has explored various solutions to mitigate this problem. One approach involves increasing the thickness of the bottom oxide in the gate trench, which can be challenging for very high-voltage devices. Another approach, as seen in the work by Zhou, Qi, et al. "A novel kilovolts GaN vertical superjunction MOSFET with trench gate: Approach for device design and optimization." IEEE Journal of Emerging and Selected Topics in Power Electronics 7.3 (2019): 1440-1448, utilizes a super-junction type of device design to alleviate the high electric fields at the bottom of the gate trench. However, this solution introduces complexity in device design, including the need for deep p-GaN filled trenches, control of threshold voltage, and maintaining charge balance between p-type and n-type pillars.

Despite these efforts, the industry continues to seek more effective and efficient ways to address the challenges associated with high electric fields at the gate trench corners in vertical GaN devices. There remains a need for further advancements in the field to develop novel designs and manufacturing methods that can overcome these obstacles without resorting to ion implantation, which is currently not a viable option for GaN due to the high temperatures required for impurity activation.

There is thus still a need in the art for devices and methods that address at least some of the above problems.

### Summary of the invention

It is an object of the present invention to provide a good field effect transistor or methods for forming the field effect transistor.

The above objective is accomplished by a method and apparatus according to the present invention.

In a first aspect, the present invention relates to a field effect transistor comprising:
- a III-nitride semiconductor stack comprising a III-nitride semiconductor material, the III-nitride semiconductor stack comprising:
   a drain layer doped with an n-type dopant,
   a drift layer over the drain layer, wherein the drift layer is doped with the n-type dopant, wherein a concentration of the n-type dopant in the drift layer is lower than a concentration of the n-type dopant in the drain layer,
   a body layer over the drift layer, wherein the body layer is doped with a p-type dopant, wherein a concentration of the p-type dopant at a top of the body layer is higher than a concentration of the p-type dopant at a bottom of the body layer, and
   a source layer over the body layer, wherein the source layer is doped with the n-type dopant, and
- an n-doped region, formed of the III-nitride semiconductor material, extending from the drift layer into a first part of the body layer, wherein a height in the stack of a top surface of the n-doped region is located below a height in the stack of the top of the body layer, and
- a trench extending from a top surface of the III-nitride semiconductor stack, through the source layer, and only an upper part of the body layer, wherein said upper part is adjacent to the first part,
- a gate dielectric covering surfaces of the trench,
- a gate electrode over the gate dielectric,
wherein a first region of a bottom surface of the gate dielectric is in physical contact with the top surface of the n-doped region.

In a second aspect, the present invention relates to a method for forming a field effect transistor, the method comprising:
i) obtaining:
   a III-nitride semiconductor stack comprising a III-nitride semiconductor material, the III-nitride semiconductor stack comprising:
      a drain layer doped with an n-type dopant,
      a drift layer over the drain layer, wherein the drift layer is doped with the n-type dopant, wherein a concentration of the n-type dopant in the drift layer is lower than a concentration of the n-type dopant in the drain layer,
      a body layer over the drift layer, wherein the body layer is doped with a p-type dopant, wherein a concentration of the p-type dopant at a top of the body layer is higher than a concentration of the p-type dopant at a bottom of the body layer, and
      a source layer over the body layer, wherein the source layer is doped with the n-type dopant, and
   an n-doped region, formed of the III-nitride semiconductor material, extending from the drift layer at least into a first part of the body layer,
ii) etching a trench, extending from a top surface of the III-nitride semiconductor stack, through the source layer and the upper body layer, into the body layer, so that a first region of a bottom surface of the trench is formed by a top surface of the n-doped region, wherein a height in the stack of said top surface is located below a height in the stack of a top of the body layer,
iii) depositing, on surfaces of the gate trench, a gate dielectric, and
iv) depositing, over the gate dielectric, a gate electrode.

It is an advantage of embodiments of the present invention that a vertical field effect transistor may be provided for mitigating the problem of high electric fields at the gate trench corners in vertical or semi-vertical type III-nitride semiconductor field effect transistors. It is a further advantage of embodiments of the present invention that it can be implemented without the need for ion implantation. Ion implantation is a significant challenge in III-nitride semiconductor field effect transistor fabrication due to the high temperatures required for activation.

It is an advantage of embodiments of the present invention that controlled channel doping can be achieved through an adapted body layer p-doping profile, which may contribute to the reduction of electric fields at corners of the gate trench in the device.

Particular and preferred aspects of the invention are set out in the accompanying independent and dependent claims. Features from the dependent claims may be combined with features of the independent claims and with features of other dependent claims as appropriate and not merely as explicitly set out in the claims.

Although there has been constant improvement, change and evolution of devices in this field, the present concepts are believed to represent substantial new and novel improvements, including departures from prior practices, resulting in the provision of more efficient, stable and reliable devices of this nature.

The above and other characteristics, features and advantages of the present invention will become apparent from the following detailed description, taken in conjunction with the accompanying drawings, which illustrate, by way of example, the principles of the invention. This description is given for the sake of example only, without limiting the scope of the invention. The reference figures quoted below refer to the attached drawings.

### Brief description of the drawings

FIG. 1 to FIG. 7 are cross-sectional views of a structure in consecutive steps of a method according to a first approach for forming a field effect transistor in accordance with embodiments of the present invention.
FIG. 8 to FIG. 11 are cross-sectional views of a structure in consecutive steps of a method according to a second approach for forming a field effect transistor in accordance with embodiments of the present invention.

In the different figures, the same reference signs refer to the same or analogous elements.

### Description of illustrative embodiments

The present invention will be described with respect to particular embodiments and with reference to certain drawings but the invention is not limited thereto but only by the claims. The drawings described are only schematic and are non-limiting. In the drawings, the size of some of the elements may be exaggerated and not drawn on scale for illustrative purposes. The dimensions and the relative dimensions do not correspond to actual reductions to practice of the invention.

Furthermore, the terms first, second, third and the like in the description and in the claims, are used for distinguishing between similar elements and not necessarily for describing a sequence, either temporally, spatially, in ranking or in any other manner. It is to be understood that the terms so used are interchangeable under appropriate circumstances and that the embodiments of the invention described herein are capable of operation in other sequences than described or illustrated herein.

Moreover, the terms top, bottom, over, under and the like in the description and the claims are used for descriptive purposes and not necessarily for describing relative positions. It is to be understood that the terms so used are interchangeable under appropriate circumstances and that the embodiments of the invention described herein are capable of operation in other orientations than described or illustrated herein.

It is to be noticed that the term "comprising", also used in the claims, should not be interpreted as being restricted to the means listed thereafter; it does not exclude other elements or steps. It is thus to be interpreted as specifying the presence of the stated features, integers, steps or components as referred to, but does not preclude the presence or addition of one or more other features, integers, steps or components, or groups thereof. Thus, the scope of the expression "a device comprising means A and B" should not be interpreted as being limited to devices consisting only of components A and B. It means that with respect to the present invention, the only relevant components of the device are A and B. The term "comprising" therefore covers the situation where only the stated features are present and the situation where these features and one or more other features are present. The word "comprising" according to the invention therefore also includes as one embodiment that no further components are present. When the word 'comprising' is used to describe an embodiment in this application, it is to be understood that an alternative version of the same embodiment, wherein the term 'comprising' is replaced by 'consisting of', is also encompassed within the scope of the present invention.

Similarly, it is to be noticed that the term "coupled" should not be interpreted as being restricted to direct connections only. The terms "coupled" and "connected", along with their derivatives, may be used. It should be understood that these terms are not intended as synonyms for each other. Thus, the scope of the expression "a device A coupled to a device B" should not be limited to devices or systems wherein an output of device A is directly connected to an input of device B. It means that there exists a path between an output of A and an input of B which may be a path including other devices or means. "Coupled" may mean that two or more elements are either in direct physical or electrical contact, or that two or more elements are not in direct contact with each other but yet still co-operate or interact with each other.

Reference throughout this specification to "one embodiment" or "an embodiment" means that a particular feature, structure or characteristic described in connection with the embodiment is included in at least one embodiment of the present invention. Thus, appearances of the phrases "in one embodiment" or "in an embodiment" in various places throughout this specification are not necessarily all referring to the same embodiment, but may. Furthermore, the particular features, structures or characteristics may be combined in any suitable manner, as would be apparent to one of ordinary skill in the art from this disclosure, in one or more embodiments.

Similarly it should be appreciated that in the description of exemplary embodiments of the invention, various features of the invention are sometimes grouped together in a single embodiment, figure, or description thereof for the purpose of streamlining the disclosure and aiding in the understanding of one or more of the various inventive aspects. This method of disclosure, however, is not to be interpreted as reflecting an intention that the claimed invention requires more features than are expressly recited in each claim. Rather, as the following claims reflect, inventive aspects lie in less than all features of a single foregoing disclosed embodiment. Thus, the claims following the detailed description are hereby expressly incorporated into this detailed description, with each claim standing on its own as a separate embodiment of this invention.

Furthermore, while some embodiments described herein include some but not other features included in other embodiments, combinations of features of different embodiments are meant to be within the scope of the invention, and form different embodiments, as would be understood by those in the art. For example, in the following claims, any of the claimed embodiments can be used in any combination.

Furthermore, some of the embodiments are described herein as a method or combination of elements of a method that can be implemented by a processor of a computer system or by other means of carrying out the function. Thus, a processor with the necessary instructions for carrying out such a method or element of a method forms a means for carrying out the method or element of a method. Furthermore, an element described herein of an apparatus embodiment is an example of a means for carrying out the function performed by the element for the purpose of carrying out the invention.

In the description provided herein, numerous specific details are set forth. However, it is understood that embodiments of the invention may be practiced without these specific details. In other instances, well-known methods, structures and techniques have not been shown in detail in order not to obscure an understanding of this description.

As used herein, and unless otherwise specified, the term "III-nitride semiconductor material" refers to a semiconductor material composed of elements from group III of the periodic table combined with nitrogen. Examples of specific embodiments of III-nitride semiconductor materials include gallium nitride (GaN), aluminum nitride (AIN), indium nitride (InN), and their ternary and quaternary alloys such as AlGaN, InGaN, AlInN, and AlGaInN.

As used herein, and unless otherwise specified, the term "n-type dopant" refers to an impurity added to a semiconductor material that provides additional free electrons, thereby increasing the material's conductivity due to the movement of these electrons. Examples of specific embodiments of n-type dopants for III-nitride semiconductor materials include silicon (Si), germanium (Ge), selenium (Se), and tellurium (Te).

As used herein, and unless otherwise specified, the term "p-type dopant" refers to an impurity added to a semiconductor material that creates "holes" or the absence of electrons, which can move and carry positive charge, thereby increasing the material's conductivity due to the movement of these holes. Examples of specific embodiments of p-type dopants for III-nitride semiconductor materials include magnesium (Mg), zinc (Zn), beryllium (Be), and calcium (Ca).

As used herein, and unless otherwise specified, the term "vertical field effect transistor" refers to a field effect transistor in which the current flows vertically through the semiconductor layers from the source to the drain, which are located on opposite sides of the semiconductor stack. A "semi-vertical field effect transistor" refers to a field effect transistor where the current flow is substantially vertical but may include some lateral components due to the device structure.

The invention will now be described by a detailed description of several embodiments of the invention. It is clear that other embodiments of the invention can be configured according to the knowledge of persons skilled in the art without departing from the technical teaching of the invention, the invention being limited only by the terms of the appended claims.

In a first aspect, the present invention relates to a field effect transistor comprising:
- a III-nitride semiconductor stack comprising a III-nitride semiconductor material, the III-nitride semiconductor stack comprising:
   a drain layer doped with an n-type dopant,
   a drift layer over the drain layer, wherein the drift layer is doped with the n-type dopant, wherein a concentration of the n-type dopant in the drift layer is lower than a concentration of the n-type dopant in the drain layer,
   a body layer over the drift layer, wherein the body layer is doped with a p-type dopant, wherein a concentration of the p-type dopant at a top of the body layer is higher than a concentration of the p-type dopant at a bottom of the body layer, and
   a source layer over the body layer, wherein the source layer is doped with the n-type dopant, and
- an n-doped region, formed of the III-nitride semiconductor material, extending from the drift layer into a first part of the body layer, wherein a height in the stack of a top surface of the n-doped region is located below a height in the stack of the top of the body layer, and
- a trench extending from a top surface of the III-nitride semiconductor stack, through the source layer, and only an upper part of the body layer, wherein said upper part is adjacent to the first part,
- a gate dielectric covering surfaces of the trench,
- a gate electrode over the gate dielectric,
wherein a first region of a bottom surface of the gate dielectric is in physical contact with the top surface of the n-doped region.

In embodiments, a height of the body layer may be from 250 nm to 3.5 µm. In embodiments, the concentration of the p-type dopant in the body layer may be from 1.0×10¹⁹ to 3.0×10¹⁹ atoms/cm³. The concentration may be as determined by Rutherford Backscattering Spectroscopy.

In embodiments, a height from the bottom of the body layer to the top surface of the n-type layer may be from 200 nm to 2.0 µm.

In embodiments, the body layer comprises a lower body layer over the drift layer and an upper body layer over the lower body layer, wherein a concentration of the p-type dopant in the upper body layer is higher than a concentration of the p-type dopant in the lower body layer. In embodiments, the body layer comprises a plurality of layers, including the upper and lower body layer. Preferably, a concentration of the p-type dopant in the layers of the plurality of layers increases with a height of the layer of the plurality of layers in the stack of layers, so that higher layers have a higher concentration of the p-type dopant. In embodiments, the lower body layer and the upper body layer may be separate, distinguishable layers. Each of the lower body layer and the upper body layer may have a uniform concentration of the p-type dopant. These embodiments may be most straightforward to form in practice.

In embodiments, the concentration of the p-type dopant in the upper body layer may be at least 20% higher than a concentration of the p-type dopant in the lower body layer. In embodiments, the concentration of the p-type dopant in the upper body layer may be from 10 to 1000 times higher than a concentration of the p-type dopant in the lower body layer.

In embodiments, the n-doped region extends into a first part of the lower body layer, wherein a height in the stack of a top surface of the n-doped region is located below a height in the stack of a bottom surface of the upper body layer. In embodiments, a ratio of a first height from the top surface of the n-doped region to a top surface of the lower body layer, and a second height from a bottom surface of the lower body layer to the top surface of the lower body layer, may be from 0.02 to 0.98, e.g., from 0.05 to 0.8. In embodiments, a ratio of a first height from the corner of the trench to a top surface of the lower body layer, and a second height from a bottom surface of the lower body layer to the top surface of the lower body layer, may be from 0.02 to 0.98, e.g., 0.05 to 0.8.

In embodiments, a height of the lower body layer may be from 50 nm to 1.5 µm. In embodiments, a height of the upper body layer may be from 200 nm to 2.0 µm. In embodiments, a ratio of the height of the lower body layer to the height of the upper body layer is from 0.1 to 50.

In alternative embodiments, the body layer may contain a gradient of the p-type dopant. In these embodiments, preferably, a concentration of the p-type dopant increases from the bottom of the body layer to the top of the body layer. In embodiments, the concentration of the p-type dopant at the top of the body layer may be at least 20% higher than a concentration of the p-type dopant in the body layer at a height in the stack of layers of the bottom surface of the gate dielectric. In embodiments, the concentration of the p-type dopant in the upper body layer may be from 10 to 1000 times higher than a concentration of the p-type dopant in the body layer at a height in the stack of layers of the bottom surface of the gate dielectric.

In embodiments, a ratio of a first height from the top surface of the n-doped region to a top surface of the body layer, and a second height from a bottom surface of the body layer to the top surface of the body layer, may be from 0.02 to 0.8. In embodiments, the first height may be from 20 nm to 500 nm. In embodiments, the second height may be from 200 nm to 2.0 µm.

In embodiments, a ratio of a first height from the corner of the trench to a top surface of the lower body layer, and a second height from a bottom surface of the lower body layer to the top surface of the lower body layer, may be from 0.02 to 0.8. In embodiments, the first height may be from 200 nm to 1.2 µm. In embodiments, the second height may be from 200 nm to 2.5 µm.

In embodiments, the interface area between the bottom surface of the gate dielectric and the top surface of the n-doped region may be from 20% to 80%, preferably from 20% to 70%, of the area of the bottom surface of the gate dielectric. In embodiments, the first region may comprise a center of the bottom surface of the gate dielectric. In other words, the n-doped region may contact the center of the bottom surface of the gate dielectric. In embodiments, a peripheral region of the bottom surface, surrounding the first region may contact the lower body layer. In embodiments, a bottom corner of the trench, e.g., of the gate dielectric, may contact the lower body layer. In other words, this corner is where the gate dielectric and the (lower) body layer meet at an angle, thereby forming an angled interface.

In embodiments, a concentration of the n-type dopant in the n-doped region is lower than the concentration of the n-type dopant in the drain layer.

In embodiments, each of the drain layer, the drift layer, the body layer - e.g., the lower body layer and the upper body layer -, and the source layer, comprises, or is formed of, the same III-nitride semiconductor material. In embodiments, the III-nitride semiconductor material may be selected from aluminum nitride, indium nitride, and gallium nitride. In preferred embodiments, the III-nitride semiconductor material is gallium nitride. In some embodiments, the drain layer, the drift layer, the body layer - e.g., the lower body layer and the upper body layer -, and the source layer comprise, or are formed of, different III-nitride semiconductor materials. For example, the source layer may be formed of a AlGaN/GaN - typically undoped GaN - heterostructure, forming a two-dimensional electron gas at an interface between the AlGaN and the GaN, and the drain layer, the drift layer and the body layer may be formed of a same III-nitride semiconductor material, e.g., gallium nitride.

In embodiments, a height of the drain layer may be at least 50 nm, for example, from 50 nm to 2.0 µm. In embodiments, a height of the drift layer may be from 1.0 µm to 50 µm. In embodiments, a height of the source layer may be at least 20 nm, for example, from 20 nm to 1.0 µm.

In embodiments, the concentration of the n-type dopant in the drain layer may be from 1.0×10¹⁷ to 1.0×10²⁰ atoms/cm³. In embodiments, the concentration of the n-type dopant in the drift layer may be from 1.0×10¹⁵ to 1.0×10¹⁷ atoms/cm³. In embodiments, the concentration of the n-type dopant in the source layer may be from 1.0×10¹⁸ to 1.0×10²¹ atoms/cm³. The concentrations may be as determined by Rutherford Backscattering Spectroscopy.

As used herein, and unless otherwise specified, the term "p-type dopant" refers to an impurity added to a semiconductor material that creates "holes" or the absence of electrons, which can move and carry positive charge, thereby increasing the material's conductivity due to the movement of these holes. Examples of specific embodiments of p-type dopants for III-nitride semiconductor materials include magnesium (Mg), zinc (Zn), beryllium (Be), and calcium (Ca).

In embodiments, a concentration of the n-type dopant in the n-doped region may be at least 0.8 times the concentration of the n-type dopant in the drift layer. In embodiments, a concentration of the n-type dopant in the n-doped region may be from 0.8 to 10 times, e.g., from 1.0 to 10 times, a concentration of the n-type dopant in the drift layer. Preferably, the concentration of the n-type dopant in the n-doped region is larger than the concentration of the n-type dopant in the drift layer.

In embodiments, the trench may have bottom corners having an angle of from 90° to 150°, e.g., from 90° to 120°. Said angle may be that between the bottom surface of the gate dielectric and another surface of the gate dielectric, said bottom surface and said another surface being connected to each other by the corner.

In embodiments, the field effect transistor may be a vertical field effect transistor or a semi-vertical field effect transistor. Semi-vertical field effect transistors are also known as quasi-vertical field effect transistors.

Any features of any embodiment of the first aspect may be independently as correspondingly described for any embodiment of the second aspect of the present invention.

In a second aspect, the present invention relates to a method for forming a field effect transistor, the method comprising:
i) obtaining:
   a III-nitride semiconductor stack comprising a III-nitride semiconductor material, the III-nitride semiconductor stack comprising:
      a drain layer doped with an n-type dopant,
      a drift layer over the drain layer, wherein the drift layer is doped with the n-type dopant, wherein a concentration of the n-type dopant in the drift layer is lower than a concentration of the n-type dopant in the drain layer,
      a body layer over the drift layer, wherein the body layer is doped with a p-type dopant, wherein a concentration of the p-type dopant at a top of the body layer is higher than a concentration of the p-type dopant at a bottom of the body layer, and
      a source layer over the body layer, wherein the source layer is doped with the n-type dopant, and
   an n-doped region, formed of the III-nitride semiconductor material, extending from the drift layer at least into a first part of the body layer,
ii) etching a trench, extending from a top surface of the III-nitride semiconductor stack, through the source layer and the upper body layer, into the body layer, so that a first region of a bottom surface of the trench is formed by a top surface of the n-doped region, wherein a height in the stack of said top surface is located below a height in the stack of a top of the body layer,
iii) depositing, on surfaces of the gate trench, a gate dielectric, and
iv) depositing, over the gate dielectric, a gate electrode.

In embodiments, step i may comprise:
i1) obtaining the III-nitride semiconductor stack,
i2) etching, from the top surface of the III-nitride semiconductor stack, through the source layer, and the body layer, to form a trench for regrowth having a bottom surface located in the drift layer,
i3) epitaxially growing, from the bottom surface of the trench for regrowth, a III-nitride semiconductor material for forming the n-doped region.

In embodiments, step i2 may comprise:
i2') providing a hard mask over the top surface of the stack of layers, the hard mask comprising an opening exposing part of the top surface of the stack of layers for forming the trench for regrowth, and
i2") etching the stack of layers through said opening for forming the trench for regrowth, and
wherein step i3 may comprise performing said epitaxial growth in the trench for regrowth, selectively with respect to the hard mask.

In alternative embodiments, step i3 may comprise:
i3') performing said epitaxial growth so that a top surface of said epitaxially grown material is above the top surface of the stack of layers, and
i3") performing an etch back on the epitaxially grown material so that the top surface of the epitaxially grown material, after said etch back, is coplanar with the top surface of the stack of layers.

In different embodiments, step i may comprise:
ia) providing the drain layer and the drift layer,
ib) epitaxially growing, on the drift layer, a III-nitride semiconductor material for forming the n-doped region,
ic) etching the III-nitride semiconductor material to form a pillar surrounded by a trench, and
id) epitaxially growing, in the trench:
   the lower body layer over the drift layer, then
   the upper body layer over the lower body layer, and then
   the source layer over the upper body layer.

Any features of any embodiment of the second aspect may be independently as correspondingly described for any embodiment of the first aspect of the present invention.

### Example 1: First approach for forming a field effect transistor

Now follows an example of a method of forming a field effect transistor in accordance with embodiments of the present invention.

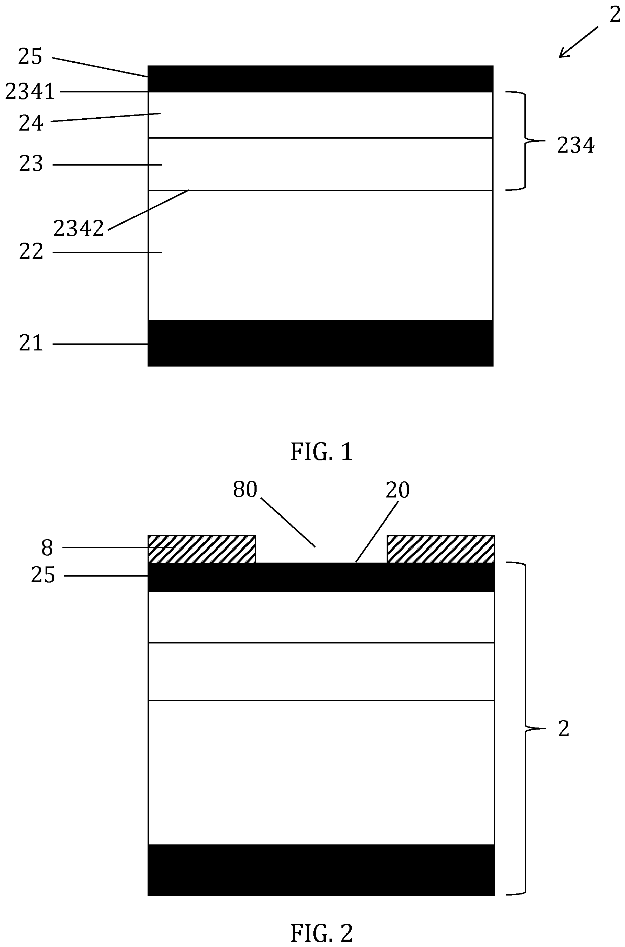

Reference is made to FIG. 1, which is a cross-sectional view of a stack of layers 2 in accordance with embodiments of the present invention.

The stack of layers 2 includes a drain layer 21 doped with an n-type dopant, which may serve as the drain contact.

Over, e.g., on top, of the drain layer 21, the stack of layers 2 comprises a drift layer 22. The drift layer 22 is doped with the n-type dopant, wherein a concentration of the n-type dopant in the drift layer 22 is lower than a concentration of the n-type dopant in the drain layer 21. In the field effect to be formed, the drift layer 22 is typically responsible for voltage blocking in the OFF-state of the device.

Over, e.g., on top, of the drift layer 22, the stack of layers 2 comprises a lower body layer 23. The lower body layer 23 is doped with a p-type dopant. Over, e.g., on top, of the lower body layer 23, the stack of layers 2 comprises an upper body layer 24. A concentration of the p-type dopant in the upper body layer 24 is higher than a concentration of the p-type dopant in the lower body layer 23. In the present example, the lower body layer 23 and the upper body layer 24 together form a body layer. In the present example, the lower body layer 23 and the upper body layer 24, together, form a body layer 234 of the stack of layers 2 having a concentration of the p-type dopant that is higher at a top 2341 of the body layer 234, or of the upper body layer 24, than at a bottom 2342 of the body layer 234, or of the lower body layer 23.

Instead of the lower body layer 23 and the upper body layer 24 that are distinguishable from each other, the body layer 234 could contain a gradient of the p-type dopant.

Over, e.g., on, the upper body layer 24, the stack of layers 2 comprises a source layer 25. The source layer 25 is doped with the n-type dopant. The source layer 25 may serve as the source contact for the field effect transistor that is to be formed.

Reference is made to FIG. 2. A mask 8 is formed over a top surface 20 of the stack of layers 2, which is, in the present example, the top surface 20 of the source layer 25. The mask 8 comprises an opening 80 exposing part of the top surface 20 of the stack of layer 2 for forming a trench for regrowth.

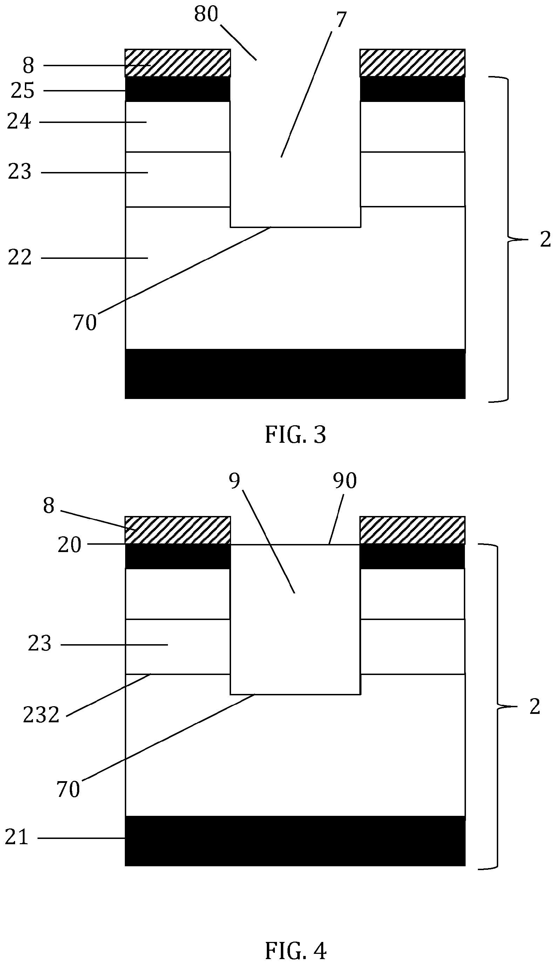

Reference is made to FIG. 3. By etching the stack of layers 2, selectively with respect to the mask 8, through the opening 80, etching through the source layer 25, the upper body layer 24 and the lower body layer 23, a trench 7 for regrowth is formed, having a bottom surface 70 located in the drift layer 22. In this example, said etching is performed into the drift layer 22, i.e., also part of the drift layer 22 is etched, this is not essential. For example, said etching may be terminated when the drift layer 22 is reached.

Reference is made to FIG. 4. Subsequently, in this example, a III-nitride semiconductor material 9 is epitaxially grown, from the trench bottom 70 and selectively with respect to the mask 8. A concentration of the n-type dopant in the III-nitride semiconductor material 9 is lower than the concentration of the n-type dopant in the drain layer 21. The III-nitride semiconductor material 9 is grown for forming the n-doped region, i.e., the n-doped region is formed from the III-nitride semiconductor material 9. The III-nitride semiconductor material 9 may be at least grown so that a top surface 90 of the III-nitride semiconductor material 9 is at a height of or above a top surface of the n-doped region that is to be formed. Thus, the III-nitride semiconductor material 9 may be at least grown so that a top surface 90 of the III-nitride semiconductor material 9 is above a bottom surface 232 of the lower body layer 23. In the present example, the III-nitride semiconductor material 9 is grown to completely fill the trench. The mask 8 may be selectively removed. An etch back may be performed so that the top surface 90 of the epitaxially grown material 9 is coplanar with the top surface 20 of the stack of layers 2.

Alternatively, the mask 8 could be removed first, and subsequently, the III-nitride semiconductor material 9 could be grown over exposed surfaces of the III-nitride semiconductor stack 2, including over, e.g., on, trench surfaces 70 and over, e.g., on, the top surface 20 of the stack 2. Said growth may be followed by an etch back, so that the top surface 90 of the III-nitride semiconductor material 9 is coplanar with the top surface 20 of the stack of layers 2.

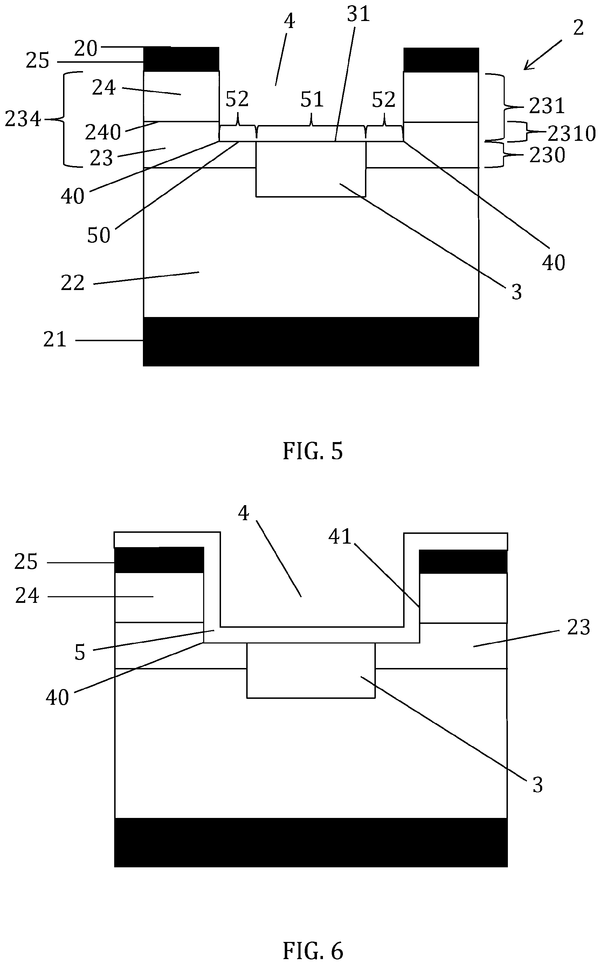

Reference is made to FIG. 5. A trench 4 for forming the gate may now be formed, e.g., by an etch, extending from the top surface 20 of the III-nitride semiconductor stack 2, through the source layer 25 and the upper body layer 24, into the lower body layer 23, so that a first region 51 of a bottom surface 50 of the trench 4 is formed by a top surface 31 of the n-doped region 3. The III-nitride semiconductor material 9 may be etched when forming the trench 4 so as to form said n-doped region 3 from the III-nitride semiconductor material 9, as shown in FIG. 5. This may be done by removing the III-nitride semiconductor material 9 located in at a height in the stack 2 of the source layer 25, the upper body layer 24, and an upper part 2310 of the lower body layer 23. In other words, this may be done by removing the III-nitride semiconductor material 9 located in at a height in the stack 2 of the source layer 25, and an upper part 231 of the body layer 234.

Although, in the present example, the III-nitride semiconductor material 9 is removed to form the n-doped region 3, alternatively, the III-nitride semiconductor material 9 could be deposited so that the top surface 90 of the III-nitride semiconductor material 9 is at a height within the lower body layer. In said alternative, said etching to form the trench 4 for forming the gate may be performed without etching the III-nitride semiconductor material 9. For example, the III-nitride semiconductor material 9 may form the n-doped region 3 directly after its deposition.

The n-doped region 3 is formed so that it extends from the drift layer 22 at least into a first part 230 of the lower body layer 23. The upper part 2310 of the lower body layer 23, and thus, the upper part 231 of the body layer 234, are adjacent to said first part 230 of the lower body layer 23. A height in the stack 2 of a top surface 31 of the n-doped region 3 is located below a height in the stack 2 of a bottom surface 240 of the upper body layer 24. As the n-doped region 3 is formed of the III-nitride semiconductor material 9, a concentration of the n-type dopant in the n-doped region 3 is the same as the concentration of the n-type dopant in the III-nitride semiconductor material 9. Thus, the concentration of the n-type dopant in the n-doped region 3 is lower than the concentration of the n-type dopant in the drain layer 21.

The n-doped region 3 is in physical contact with the lower body layer 23. Thereby, a junction may be formed between the n-doped region 3 and the lower body layer 23.

In the present example, the trench 4 for forming the gate is wider than the trench for regrowth (i.e., the trench 7 shown in FIG. 3). In this example, the bottom surface 50 further comprises a peripheral region 52 surrounding the first region 51. The peripheral region 52 may be formed by the lower body layer 23. The peripheral region 52 may provide a separation of bottom corners 40 of the trench 4 from the n-doped region 3. For example, each of the bottom corners 40 of the trench 4 may, thereby, be formed by the lower body layer 23.

Reference is made to FIG. 6. A gate dielectric 5 is deposited over, e.g., on, surfaces 41 of the trench 4. In this example, the gate dielectric 5 is formed of a dielectric material that is uniformly deposited over said surfaces 41, exposed to the trench, of the n-doped region 3, the the lower body layer 23, the upper body layer 24 and the source layer 25. Deposition of the dielectric material may, for example, be performed by physical vapor deposition or atomic layer deposition. The gate dielectric 5 is deposited in contact with the corners 40 of the trench 4.

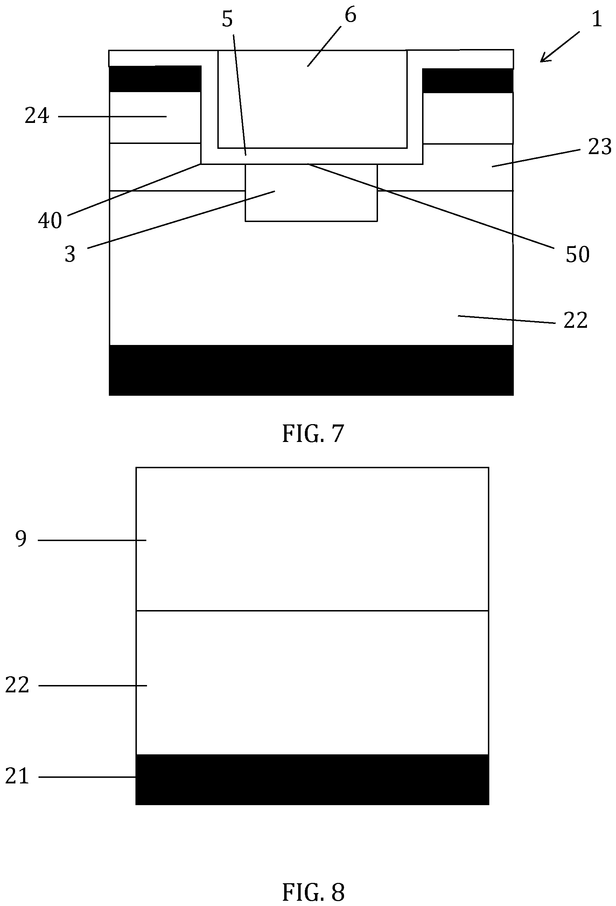

Reference is made to FIG. 7. A gate electrode 6 is formed over, e.g., on, the gate dielectric 5. Said gate electrode 6 may be formed by deposition of an electrode material over the gate dielectric 5.

Thereby, a field effect transistor 1 in accordance with embodiments of the present invention may be formed.

Embodiments of the present invention protect the bottom corners 40 of the trench from large electric fields in the OFF state of the field effect transistor 1. Indeed, at the bottom corners 40, a voltage difference between the gate metal 6 (in the OFF state, at zero voltage) and the lower body layer 23 may be limited.

In contrast, in conventional vertical field effect transistors of the state of the art, at said bottom corners, the gate metal is, instead, proximate to the drift layer, that is in electrical contact with the drain layer that is at a high voltage. Therefore, in conventional vertical field effect transistors of the state of the art, a high voltage difference may be present at the corner in a classical device, which may result in breakdown of the dielectric layer at the bottom corners. This problem may be mitigated in embodiments of the present invention.

In embodiments of the present invention, due to the higher concentration of the p-type dopant in the upper body layer 24 than in the lower body layer 23, a main, vertical channel may be formed in the upper body layer 24, having a higher threshold voltage than that of a secondary channel formed in the lower body layer 23, at the bottom surface 50 and the bottom corners 40 of the gate dielectric 5. The overall threshold voltage of the field effect transistor 1 is typically that of the vertical channel in the upper body layer 24, having the higher threshold voltage.

A main junction providing the blocking capability in an OFF-state of the field effect transistor 1 may be formed between the lower body layer 23 and the drift layer 22, and between the lower body layer 23 and the n-doped region 3. The doping densities and the geometrical dimensions of the device may be designed such that the drift layer 22 below the center of the bottom 50 of the gate trench is depleted at moderate voltages during OFF-state operation and that the depletion region at OFF-state in the lower body layer 23 is protecting the other parts of the gate trench including the corners 40.

### Example 2: Second approach for forming a field effect transistor

Reference is made to FIG. 8. In a second approach for forming a field effect transistor in accordance with embodiments of the present invention, a drain layer 21 and a drift layer 22 may be provided. Over, e.g., on the drift layer 22, a III-nitride semiconductor material 9 may be epitaxially grown. The III-nitride semiconductor material 9 is provided for forming an n-doped region. The III-nitride semiconductor material 9 is doped with an n-type dopant, wherein a concentration of the n-type dopant in the III-nitride semiconductor material 9 is lower than the concentration of the n-type dopant in the drain layer 21.

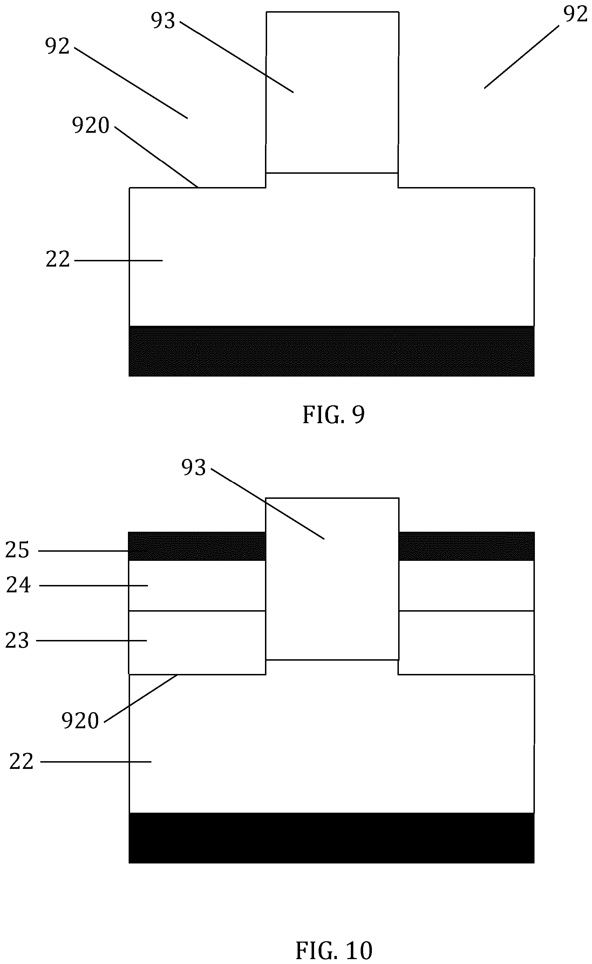

Reference is made to FIG. 9. The III-nitride semiconductor material may be etched to form a trench 92 surrounding a pillar 93 formed of the III-nitride semiconductor material. Said etch is, in this example, performed so that a bottom surface 920 of the trench 92 is located in the drift layer 22. In particular, in the present invention, said etch is performed proceeding into the drift layer 22. Alternatively, the etch could be terminated when reaching the drift layer 22. Still alternatively, the bottom surface 920 of the trench 92 could be located in the III-nitride semiconductor material, i.e., could be formed by the III-nitride semiconductor material. In the latter case, the etch may be terminated before the drift layer 22 is reached.

Reference is made to FIG. 10. In said trench surrounding the pillar 93, a lower body layer 23 may be epitaxially grown over the drift layer 22, over, e.g., on, said bottom surface 920. Then an upper body layer 24 may be epitaxially grown over the lower body layer 23. Then a source layer 25 may be epitaxially grown over the upper body layer 24.

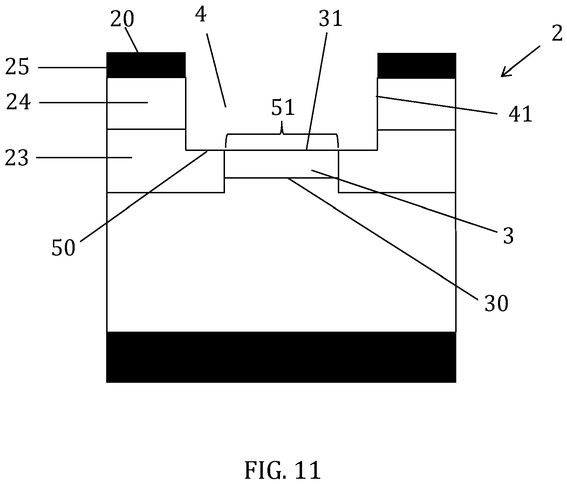

Reference is made to FIG. 11. A trench 4 for forming the gate may be formed, e.g., by an etch, extending from the top surface 20 of the III-nitride semiconductor stack 2, through the source layer 25 and the upper body layer 24, into the lower body layer 23, so that a first region 51 of a bottom surface 50 of the trench 4 is formed by a top surface 31 of the n-doped region 3. The structure that is thus achieved may be the same as that formed in FIG. 5, except that a bottom surface 30 of the n-doped region 3 may be located at a different height within the stack 2.

Similarly as in Example 1, the method may proceed with depositing, covering surfaces 41 of the trench 4, the gate dielectric and, subsequently, the gate electrode, so as to form the field effect transistor in accordance with embodiments of the present invention. The field effect transistor that would be formed in Example 2 may have the same advantages as the field effect transistor formed in Example 1.

It is to be understood that although preferred embodiments, specific constructions and configurations, as well as materials, have been discussed herein for devices according to the present invention, various changes or modifications in form and detail may be made without departing from the scope of this invention. Steps may be added or deleted to methods described within the scope of the present invention.

## Claims

1. A field effect transistor (1) comprising:
- a III-nitride semiconductor stack (2) comprising a III-nitride semiconductor material, the III-nitride semiconductor stack (2) comprising:
a drain layer (21) doped with an n-type dopant,
a drift layer (22) over the drain layer (21), wherein the drift layer (22) is doped with the n-type dopant, wherein a concentration of the n-type dopant in the drift layer (22) is lower than a concentration of the n-type dopant in the drain layer (21),
a body layer (234) over the drift layer (22), wherein the body layer (234) is doped with a p-type dopant, wherein a concentration of the p-type dopant at a top (2341) of the body layer (234) is higher than a concentration of the p-type dopant at a bottom (2342) of the body layer (234), and
a source layer (25) over the body layer (234), wherein the source layer (25) is doped with the n-type dopant, and
- an n-doped region (3), formed of the III-nitride semiconductor material, extending from the drift layer (22) into a first part (230) of the body layer (234), wherein a height in the stack (2) of a top surface (31) of the n-doped region (3) is located below a height in the stack (2) of the top (2341) of the body layer (234), and
- a trench (4) extending from a top surface (20) of the III-nitride semiconductor stack (2), through the source layer (25), and only an upper part (231) of the body layer (234), wherein said upper part (231) is adjacent to the first part (230),
- a gate dielectric (5) covering surfaces (41) of the trench (4),
- a gate electrode (6) over the gate dielectric (5),
wherein a first region (51) of a bottom surface (50) of the gate dielectric (5) is in physical contact with the top surface (31) of the n-doped region (3).

2. The field effect transistor (1) of claim 1, wherein an interface area between the bottom surface (50) of the gate dielectric (51) and the top surface (31) of the n-doped region (3) is from 20% to 80%, preferably from 20% to 70%, of an area of the bottom surface (50) of the gate dielectric (5).

3. The field effect transistor (1) of any of the previous claims, wherein the body layer (234) comprises a lower body layer (23) over the drift layer (22) and an upper body layer (24) over the lower body layer (23), wherein a concentration of the p-type dopant in the upper body layer (24) is higher than a concentration of the p-type dopant in the lower body layer (23).

4. The field effect transistor (1) of claim 3, wherein the concentration of the p-type dopant in the upper body layer (24) is at least 20% times higher than a concentration of the p-type dopant in the lower body layer (23).

5. The field effect transistor (1) of claim 4, wherein the concentration of the p-type dopant in the upper body layer (24) is from 10 to 1000 times higher than a concentration of the p-type dopant in the lower body layer (23).

6. The field effect transistor (1) of any of claims 3 to 5, wherein a ratio of a first height from the top surface (31) of the n-doped region (3) to a top surface (240) of the lower body layer (23), and a second height from a bottom surface (232) of the lower body layer (23) to the top surface (240) of the lower body layer (23), is from 0.02 to 0.98.

7. The field effect transistor (1) of any of claims 3 to 6, wherein a ratio of a first height from the corner (40) of the trench (4) to a top surface (240) of the lower body layer (23), and a second height from a bottom surface (230) of the lower body layer (23) to the top surface (231) of the lower body layer (23), is from 0.05 to 0.8.

8. The field effect transistor (1) of any of the previous claims, wherein the first region (51) comprises a center of the bottom surface (50) of the gate dielectric (5).

9. The field effect transistor (1) of any of the previous claims, wherein a concentration of the n-type dopant in the n-doped region is from 0.8 to 10 times a concentration of the n-type dopant in the drift layer (22).

10. The field effect transistor (1) of any of the previous claims, wherein the trench (4) has bottom corners (40) having an angle of from 90° to 150°.

11. The field effect transistor (1) of any of the previous claims, wherein a concentration of the n-type dopant in the n-doped region (3) is at least 0.8 times the concentration of the n-type dopant in the drift layer (22).

12. A method for forming a field effect transistor (1), the method comprising:
i) obtaining:
a III-nitride semiconductor stack (2) comprising a III-nitride semiconductor material, the III-nitride semiconductor stack (2) comprising:
a drain layer (21) doped with an n-type dopant,
a drift layer (22) over the drain layer (21), wherein the drift layer (22) is doped with the n-type dopant, wherein a concentration of the n-type dopant in the drift layer (22) is lower than a concentration of the n-type dopant in the drain layer (21),
a body layer (234) over the drift layer (22), wherein the body layer (234) is doped with a p-type dopant, wherein a concentration of the p-type dopant at a top (2341) of the body layer (234) is higher than a concentration of the p-type dopant at a bottom (2342) of the body layer (234), and
a source layer (25) over the body layer (234), wherein the source layer (25) is doped with the n-type dopant, and
an n-doped region (3), formed of the III-nitride semiconductor material, extending from the drift layer (22) at least into a first part (230) of the body layer (234),
ii) etching a trench (4), extending from a top surface (20) of the III-nitride semiconductor stack (2), through the source layer (25) and the upper body layer (24), into the body layer (234), so that a first region (51) of a bottom surface (50) of the trench (4) is formed by a top surface (31) of the n-doped region (3), wherein a height in the stack (2) of said top surface (31) is located below a height in the stack (2) of a top (2341) of the body layer (234),
iii) depositing, on surfaces (41) of the gate trench (4), a gate dielectric (5), and
iv) depositing, over the gate dielectric (5), a gate electrode (6).

13. The method of claim 12, wherein step i comprises:
i1) obtaining the III-nitride semiconductor stack (2),
i2) etching, from the top surface (20) of the III-nitride semiconductor stack (2), through the source layer (25), and the body layer (234), to form a trench (7) for regrowth having a bottom surface (70) located in the drift layer (22),
i3) epitaxially growing, from the bottom surface (70) of the trench (7) for regrowth, a III-nitride semiconductor material (9) for forming the n-doped region (3).

14. The method of claim 13, wherein step i2 comprises:
i2') providing a hard mask (8) over the top surface (20) of the stack of layers (2), the hard mask (8) comprising an opening (80) exposing part of the top surface (20) of the stack of layers (2) for forming the trench (7) for regrowth, and
i2") etching the stack of layers (2) through said opening (80) for forming the trench (7) for regrowth, and
wherein step i3 comprises performing said epitaxial growth in the trench (7) for regrowth, selectively with respect to the hard mask (8).

15. The method of claim 13, wherein step i3 comprises:
i3') performing said epitaxial growth so that a top surface (90) of said epitaxially grown material (9) is above the top surface (20) of the stack of layers (2), and
i3") performing an etch back on the epitaxially grown material (90) so that the top surface (90) of the epitaxially grown material (9), after said etch back, is coplanar with the top surface (20) of the stack of layers (2).
